Europäisches Patentamt

European Patent Office

Office européen des brevets

(19)

(11) Veröffentlichungsnummer: **0 248 267**
**A2**

# (12) EUROPÄISCHE PATENTANMELDUNG

(21) Anmeldenummer: 87107287.2

(22) Anmeldetag: **19.05.87**

(51) Int. Cl.4: **H01L 23/52** , H03K 19/003

(30) Priorität: **06.06.86 DE 3619064**

(43) Veröffentlichungstag der Anmeldung:
**09.12.87 Patentblatt 87/50**

(84) Benannte Vertragsstaaten:
**AT DE FR GB IT NL**

(71) Anmelder: **Siemens Aktiengesellschaft Berlin
und München
Wittelsbacherplatz 2
D-8000 München 2(DE)**

(72) Erfinder: **Köppe, Siegmar, Dipl.-Ing.
Am Kamp 18
D-3014 Laatzen(DE)**

(54) **Monolithisch integrierte Schaltung mit zueinander parallelen Schaltungszweigen.**

(57) Monolithisch integrierte Schaltung mit wenigstens zwei zueinander parallelen Schaltungszweigen, die jeweils einen oder mehrere Feldeffekttransistoren (T1, T2) enthalten. Zur Reduzierung von Unterbrechungsfehlern in den Transistorzuleitungen werden die Anschlußgebiete der Feldeffekttransistoren (T1, T2) so ausgebildet, daß sie eine lediglich durch die Kanalgebiete (14, 19) der letzteren unterbrochene, im übrigen jedoch in sich geschlossene streifenförmige Anschlußzone (9) bilden.

FIG 2

## Monolithisch integrierte Schaltung mit zueinander parallen Schaltungszweigen

Die Erfindung bezieht sich auf eine monolithisch integrierte Schaltung mit zueinander parallelen Schaltungszweigen nach dem Oberbegriff des Patentanspruchs 1.

Bei solchen Schaltungen, mit denen beispielweise Gatterfunktionen der logischen Schaltkreistechnik realisiert werden, besteht die Schwierigkeit, daß ein Unterbrechungsfehler (stuck-open-Fehler) in einem der parallelen Schaltungszweige mittels eines der üblichen Verfahren zur automatischen Fehlererkennung schwer festzustellen ist. Diese Verfahren beruhen im einzelnen darauf, daß den Eingängen der zu überprüfenden Schaltung eine Folge von Test-Bitmustern zugeführt wird, von denen wenigstens eines so beschaffen ist, daß es für die Erkennung eines bestimmten Schaltungsfehlers geeignet ist, d.h. zu einem an den Schaltungsausgängen abgreifbaren Ausgangsbitmuster führt, das von dem bei Fehlerfreiheit zu erwartenden ausgangsseitigen Sollmuster in wenigstens einem Bit abweicht.

Falls ein Unterbrechungsfehler in einem bestimmten parallelen Schaltungszweig erkannt werden soll, genügt es jedoch nicht, den Schaltungseingängen ein Test-Bitmuster zuzuführen, das diesem Fehler individuell zugeordnet ist. Vielmehr muß die Schaltung vorher durch Anlegen eines Initialisierungs-Bitmusters in einen Vorbereitungszustand versetzt werden, der diesem Fehler ebenfalls individuell zugeordnet ist.

Da beim Anlegen eines Test-Bitmusters, das von dem individuell zugeordneten Test-Bitmuster abweicht, der Vorbereitungszustand wieder aufgehoben werden kann, müssen ganze Sequenzen von jeweils einem Initialisierungs-Bitmuster und einem unmittelbar darauffolgenden zugehörigen Test-Bitmuster an die Schaltungseingänge angelegt werden, um die parallelen Schaltungszweige einzeln auf das Vorliegen von Unterbrechungsfehlern untersuchen zu können.

Die Unterbrechungsfehler in solchen Schaltungen sind im wesentlichen durch das Abreißen von Leiterbahnen an den Kanten der Feldoxidschichten, durch mangelhafte Kontaktierungen zwischen den Anschlußbereichen der Feldeffekttransistoren und den dazugehörigen Anschlußleitungen und durch die Ablagerung von verunreinigenden Partikeln bei der Schaltungsherstellung bedingt. Dabei treten diese Probleme mit fortschreitender Verkleinerung der Schaltungsstrukturen in zunehmendem Maße in Erscheinung.

Der Erfindung liegt die Aufgabe zugrunde, eine Schaltung der eingangs genannten Art anzugeben, die hinsichtlich von Unterbrechungsfehlern in den Zuleitungen der Feldeffekttransistoren in wesentlich einfacherer Weise überprüft werden kann als das bisher möglich war. Das wird erfindungsgemäß durch eine Ausbildung nach dem kennzeichnenden Teil des Patentanspruchs 1 erreicht.

Der mit der Erfindung erzielbare Vorteil besteht insbesondere darin, daß unnötige Gefahrenquellen, die zu einem Unterbrechungsfehler in den bezüglich des Testens besonders kritischen parallelen Schaltungszweigen führen können, durch die Anwendung einer in sich geschlossenen, streifenförmigen Anschlußzone, die die Anschlußgebiete der Feldeffekttransistoren wenigstens zweier paralleler Schaltungszweige in sich vereinigt, weitgehend vermieden werden. Die außerhalb der streifenförmigen Anschlußzone auftretenden Unterbrechungsfehler sind auf relativ einfache Weise mittels einer automatischen Fehlererkennung auffindbar, so daß die Testbarkeit einer solchen Schaltung ganz wesentlich verbessert wird.

Die Ansprüche 2 bis 5 sind auf bevorzugte Ausgestaltungen und Weiterbildungen der Erfindung gerichtet.

Die Erfindung wird nachfolgend anhand von in der Zeichnung dargestellten, bevorzugten Ausführungsbeispielen näher erläutert. Dabei zeigt:

Fig. 1 die Prinzipschaltung eines an sich bekannten NAND-Gatters mit zwei Eingängen,

Fig. 2 ein nach der Erfindung ausgebildetes NAND-Gatter mit zwei Eingängen in Draufsicht,

Fig. 3 die Prinzipschaltung eines an sich bekannten AND/NOR-Gatters mit drei Eingängen,

Fig. 4 ein erfindungsgemäßes AND/NOR-Gatter der in Fig. 3 angedeuteten Art,

Fig. 5 eine erfindungsgemäß ausgebildete Schaltung mit drei parallelen Schaltungszweigen und

Fig. 6 eine erfindungsgemäße Schaltung mit vier parallelen Schaltungszweigen.

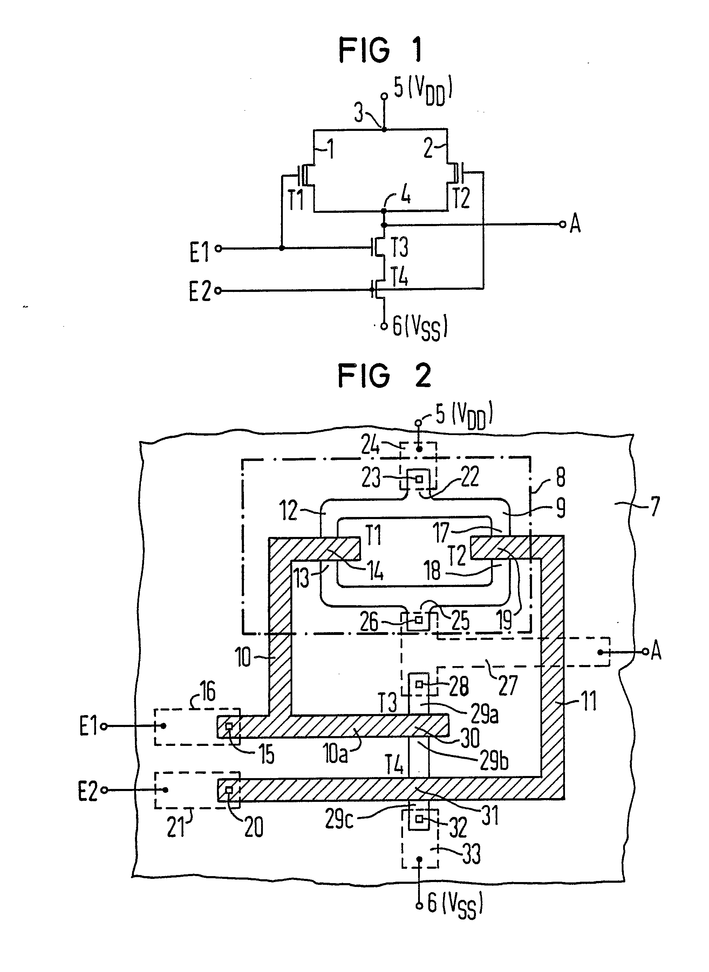

Das in Fig. 1 dargestellte, in komplementärer Schaltkreistechnik ausgebildete NAND-Gatter weist zwei zueinander parallele Schaltungszweige 1 und 2 auf, die jeweils mit einem ersten Schaltungspunkt 3 und einem zweiten Schaltungspunkt 4 verbunden sind. Der Schal tungszweig 1 enthält die Source-Drain-Strecke eines p-Kanal-Feldeffekttransistors T1, dessen Gateanschluß mit einem ersten Eingang E1 beschaltet ist. In entsprechender Weise enthält der Schaltungszweig 2 die Source-Drain-Strecke eines p-Kanal-Feldeffekttransistors T2, dessen Gateanschluß mit einem zweiten Eingang E2 verbunden ist. Der Schaltungspunkt 3 ist mit der über einen Anschluß 5 zugeführten Versorgungsspannung $V_{DD}$ beschaltet. Ein weiterer Schaltungszweig 5, der die zueinander in Serie geschalteten Source-Drain-Strecken zweier n-Kanal-Feldeffekttransistoren T3 und T4 enthält, verbindet den Schaltungspunkt 4 mit einem auf Bezugspotential $V_{SS}$ liegenden Anschluß 6. Der Gateanschluß von T3 ist an den Eingang E1 geführt, der Gateanschluß von T4 an den Eingang E2. Der mit A bezeichnete Schaltungsausgang ist oberhalb von T3 mit dem weiteren Schaltungszweig 5 verbunden.

Fig. 2 zeigt eine erfindungsgemäß ausgebildete, die NAND-Funktion nach Fig. 1 realisierende, monolithisch integrierte Schaltung in Draufsicht. Dabei ist ein dotierter Halbleiterkörper 7, z.B. aus p-leitendem Silizium, mit einer n-leitenden Wanne 8 versehen, die sich bis zu der in Fig. 2 sichtbaren Grenzfläche von 7 erstreckt und in lateraler Richtung durch eine strichpunktierte Linie begrenzt wird. In diese Wanne 8 ist eine p-leitende, in sich geschlossene streifenförmige Anschlußzone 9 eingefügt, die die Anschlußgebiete, d.h. jeweils das Source-und das Draingebiet, der beiden Transistoren T1 und T2 als Teilzonen enthält. Zwei Streifen 10, 11 aus polykristallinem Silizium, die durch eine im einzelnen nicht dargestellte elektrisch isolierende Schicht von der sichtbaren Grenzfläche des Halbleiterkörpers 7 getrennt sind, stellen die Gateelektroden von T1 und T2 einschließlich der zugeordneten Anschlußleitungen dar. Im einzelnen bilden Teilzonen 12 und 13 von 9, die in Fig. 2 unmittelbar an den abgewinkelten, horizontalen Teil des Streifens 10 angrenzen, das Source-und das Draingebiet von T1. Zwischen den Teilzonen 12 und 13 ist ein von einem Abschnitt des Streifens 10 überdeckter n-dotierter Teilbereich 14 der Wanne 8 vorhanden, der den Kanalbereich von T1 bildet. Der diesen überdeckende Abschnitt von 10 stellt die Gateelektrode dar. Der Streifen 10 wird im Bereich eines Kontaktloches 15 von einer leitenden Belegung 16, z.B. aus Aluminium, kontaktiert. Diese ist gestrichelt eingezeichnet und mit einem Anschluß verbunden, der dem Eingang E1 entspricht.

In analoger Weise besteht T2 aus den Teilzonen 17 und 18 des Streifens 9, aus dem zwischen denselben befindlichen, n-leitenden Kanalbereich 19 und aus dem diesen überdeckenden Abschnitt des Streifens 11. Der Streifen 11 wird im Bereich eines Kontaktloches 20 von einer leitenden Belegung 21, z.B. aus Aluminium, kontaktiert, die mit einem Anschluß verbunden ist, der dem Eingang E2 entspricht.

Abgesehen von den n-leitenden Kanalbereichen 14 und 19 ist die streifenförmige Anschlußzone 9, die die Source-und Draingebiete von T1 und T2 enthält, als eine in sich geschlossene Zone ausgebildet. Ein erster Ansatz 22 von 9 wird im Bereich eines Kontaktloches 23 von einer leitenden Belegung 24 kontkaktiert, deren Anschluß 5 mit $V_{DD}$ beschaltet ist. Ein zweiter Ansatz 25 von 9 wird im Bereich eines Kontaktloches 26 durch eine leitende Belegung 27 kontaktiert, die mit einem dem Ausgang A entsprechenden Anschluß versehen ist. Die Belegung 27 kontaktiert im Bereich eines Kontaktloches 28 eine in den Halbleiterkörper 7 eingefügte n-leitende Zone 29a, die sich bis zu einem von einem Ansatz 10a des Streifens 10 überdeckten Teilbereich 30 des Halbleiterkörpers 7 erstreckt. Zwischen dem Teilbereich 30 und einem von einem Abschnitt des Streifens 11 überdeckten Teilbereich 31 des Halbleiterkörpers 7 ist in Verlängerung der Zone 29a eine weitere n-leitende Zone 29b eingefügt. Schließlich ist unterhalb von 31 eine dritte n-leitende Zone 29c in 7 eingefügt, die innerhalb eines Kontaktloches 32 von einer leitenden Belegung 33 kontaktiert wird. Diese ist mit dem auf Massepotential $V_{SS}$ liegenden Anschluß 6 versehen. Dieser Teilbereich 30 von 7 stellt den Kanalbereich von T3 dar, die Teile 29a und 29b dessen Drain-und Source-Gebiet. Der Ansatz 10a bildet die Gateelektrode von T3 einschließlich der zugehörigen Anschlußleitung. Der Teilbereich 31 von 7 bildet den Kanalbereich von T4, die Teile 29b und 29c dessen Drain-und Source-Gebiet. Der Streifen 11 bildet die Gateelektrode von T4 einschließlich der zugehörigen Anschlußleitung. Die Teile 25 bis 33 bilden den in Fig. 1 mit 5 bezeichneten Schaltungszweig einschließlich der Transistoren T3 und T4.

Die leitenden Belegungen 16, 21, 24, 27 und 33 bestehen z.B. aus Aluminium und sind durch eine elektrisch isolierende Zwischenschicht von den Streifen 10, 11 aus polykristallinem Silizium getrennt. Die Kontaktlöcher 15 und 20 befinden sich in dieser isolierenden Zwischenschicht, die Kontaktlöcher 23, 26, 28 und 32 in dieser Zwischenschicht und in der darunter befindlichen elektrisch isolierenden Schicht.

Da Unterbrechungsfehler in den Zuleitungen zu den Source-und Drain-Gebieten der einzelnen Transistoren innerhalb der durch Diffusion oder Implantation hergestellten, in sich geschlossenen, streifenförmigen Anschlußzone 9 mit großer Sicherheit auszuschließen sind, können Fehler dieser Art praktisch nur noch in den außerhalb der Anschlußzone 9 liegenden Schaltungszweigen, d.h. zwischen der Anschlußzone 9 und dem Gatterausgang A oder zwischen 9 und 5 oder zwischen A und 6 auftreten. Ein in diesen Schaltungsbereichen vorhandener Unterbrechungsfehler ist aber in einfacher Weise mit Hilfe der Methoden der automatischen Fehlererkennung erfaßbar, da er sich auf alle Transistoren der Parallelzweige 1 und 2 (Fig. 1) in gleicher Weise auswirkt.

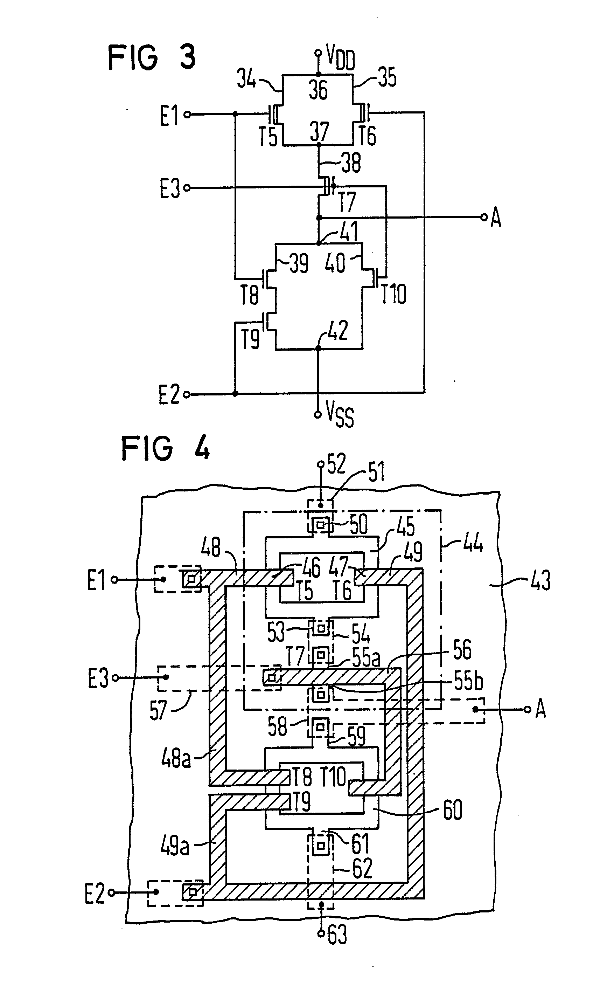

Fig. 3 zeigt ein AND/NOR-Gatter in komplementärer Schaltkreistechnik mit drei Eingängen E1 bis E3 und einem Ausgang A. Dabei sind E1 und E2 mit den Gateanschlüssen zweier p-Kanal-Feldeffekttransistoren T5 und T6 verbunden, deren Source-Drain-Strecken jeweils in zueinander parallelen Schaltungszweigen 34 und 35 liegen, welche zwei Schaltungspunkte 36 und 37 miteinander verbinden. Der Schaltungspunkt 36 ist mit einem Anschluß verbunden, der mit der Versorgungsspannung $V_{DD}$ beschaltet ist. Im Schaltungspunkt 37 ist ein weiterer Schaltungszweig 38 angeschlossen, der die Source-Drain-Strecke eines p-Kanal-Feldeffekttransistors T7 enthält. Dessen Gate wird über den Eingang E3 angesteuert. Über T7 gelangt man einerseits zum Ausgang A und andererseits zu einer aus den parallelen Schaltungszweigen 39 und 40 bestehenden Teilschaltung, die zwischen den Schaltungspunkten 41 und 42 angeordnet ist. Dabei ist 42 mit einem auf Bezugspotential liegenden Anschluß verbunden. Der Schaltungszweig 39 enthält die Source-Drain-Strecken zweier in Serie zueinander geschalteter n-Kanal-Transistoren T8 und T9, der Schaltungszweig 40 die Source-Drain-Strecke eines n-Kanal-Transistors T10. Die Gateanschlüsse von T8, T9 und T10 sind jeweils mit den Eingängen E1, E2 und E3 beschaltet.

Eine nach der Erfindung ausgebildete Halbleiterschaltung, mit der die Gatterfunktion der Schaltung nach Fig. 3 realisiert wird, ist in Fig. 4 dargestellt. Dabei wird wieder von einem p-leitenden Halbleiterkörper 43 ausgegangen, in den eine n-leitende, wannenförmige Zone 44 eingefügt ist. Die Anschlußgebiete der Feldeffekttransistoren T5 und T6, die sich in den parallelen Schaltungszweigen 34 und 35 befinden, sind zu einer p-leiten den Anschlußzone 45 zusammengefaßt, die lediglich durch zwei n-leitende Bereiche 46 und 47 unterhalb von Streifen 48 und 49 aus polykristallinem Material unterbrochen ist, im übrigen aber in sich geschlossen ist. Die Bereiche 46 und 47 stellen Kanalgebiete von T5 und T6 dar, die Streifen 48 und 49, die durch eine elektrisch isolierende Schicht von der sichtbaren Grenzfläche des Halbleiterkörpers 43 getrennt sind, bilden mit ihren oberhalb von 46 und 47 liegenden Abschnitten die Gateelektroden dieser Transistoren. Sie sind in der bereits anhand von Fig. 2 beschriebenen Weise mit den Eingängen E1 und E2 verbunden. Die Anschlußzone 45 ist über einen Ansatz 50 und eine leitende Belegung 51 wie bereits beschrieben mit einem Anschluß 52 verbunden, der mit der Versorgungsspannung $V_{DD}$ beschaltet ist. Ein zweiter Ansatz 53 von 45 ist über eine ihn kontaktierende leitende Belegung 54 mit einer p-leitenden Zone 55a verbunden, die in die n-leitende Wanne 44 eingefügt ist und sich bis zum Rand eines Streifens 56 aus polykristallinem Silizium erstreckt, der durch die elektrisch isolierende Schicht von der sichtbaren Grenzfläche des Halbleiterkörpers 43 getrennt ist. Ein weiteres p-leitendes Gebiet 55b ist so in die Wanne 44 eingefügt, das der zwischen diesem und dem Gebiet 55a liegende Teilbereich der Wanne 44 von einem Abschnitt des Streifens 56 überdeckt wird. Die Teile 55a, 55b und 56 bilden die Anschlußgebiete und das Gate des Transistors T7. Dabei ist der Streifen 56 über eine leitende Belegung 57 mit dem Eingang E3 beschaltet.

Vom Anschlußgebiet 55b gelangt man über eine leitende Belegung 58 zum Gatterausgang A und zu dem Ansatz 59 einer in den Halbleiterkörper 43 eingefügten n-leitenden, in sich geschlossenen Halbleiterzone 60, die die Anschlußgebiete der in den parallelen Schaltungszweigen 39 und 40 liegenden Transistoren T8 bis T10 in sich vereinigt. Die Gateelektrode von T8 besteht aus einem Abschnitt einer Abzweigung 48a des Streifens 48, die Gateelektrode von T9 aus einem Abschnitt einer Abzweigung 49a des Streifens 49 und die Gateelektrode von T10 aus einem Abschnitt einer Verlängerung des Streifens 56. Ein Ansatz 61 der Anschlußzone 60 ist in der bereits beschriebenen Weise über eine leitende Belegung 62 mit einem auf Bezugspotential liegenden Anschluß 63 verbunden. Wie aus Fig. 4 ersichtlich ist, enthält die Anschlußzone 60 zum Unterschied von der Anschlußzone 45 nicht nur die Anschlußgebiete zweier Feldeffekttransistoren, die in den parallelen Schaltungszweigen 34 und 35 angeordnet sind, sondern die Anschlußgebiete der Transistoren T8, T9 und T10, von denen T8 und T9 im parallelen Schaltungszweig 39 zueinander in Serie liegen.

Da sich Unterbrechungsfehler in den Zuleitungen zu den Source-und den Draingebieten der Feldeffekttransistoren bei der Schaltung nach Fig. 4 praktisch nur noch auf die Verbindung zwischen den Anschlußzonen 45 und 60 und auf die Verbindungen dieser Anschlußzonen mit den Anschlüssen 52, 63 und A beschränken und sich solche Fehler auf alle Transistoren innerhalb der parallelen Schaltungszweige 34, 35, 39 und 40 in gleicher Weise auswirken, kann eine relativ einfache Fehlererkennung mittels eingangsseitig angelegter Test-Bitmuster durchgeführt werden.

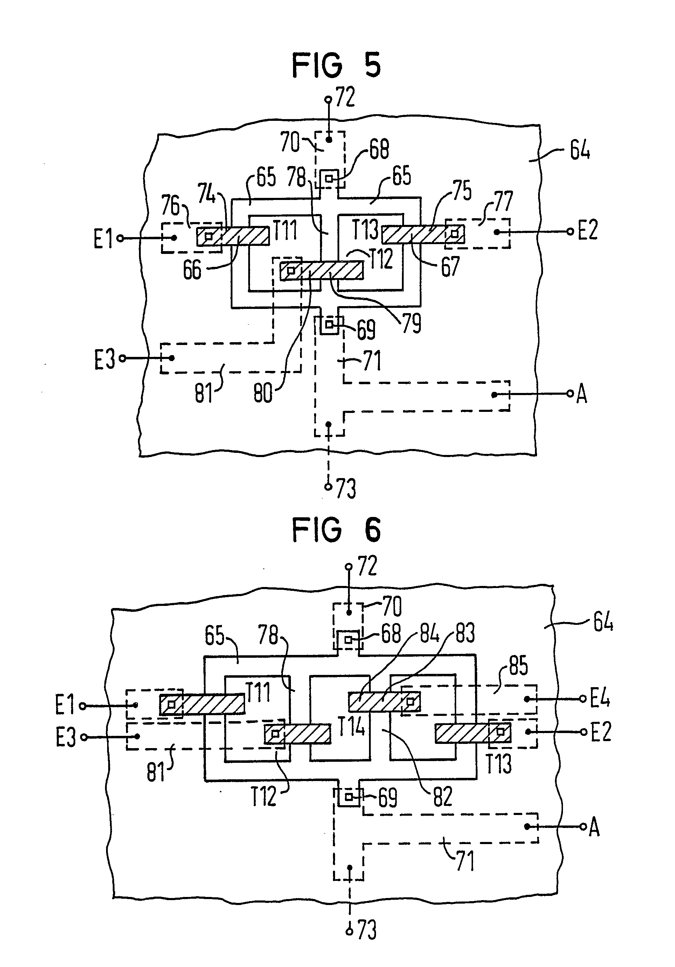

Fig. 5 zeigt einen Ausschnitt aus einer integrierten Schaltung nach der Erfindung, bei der drei zueinander parallele Schaltungszweige vorgesehen sind, von denen jeder einen Feldeffekttransistor T11, T12 bzw. T13 enthält. Hier ist eine n-leitende Wanne 64 in einen p-leitenden Halbleiterkörper eingefügt und mit einer p-leitenden Anschlußzone 65 versehen, die die Anschlußgebiete der Transistoren T11 und T13 enthält. Abgesehen von den Kanalgebieten der Transistoren T11 und T13, die mit 66 und 67 bezeichnet sind und aus Teilbereichen der Wanne bestehen, ist die Anschlußzone 65 in sich geschlossen. Die Schaltungspunkte, zwischen denen die beiden parallelen Schaltungszweige liegen, können beispielsweise durch die Kontaktierungen in den Bereichen der Kontaktlöcher 68 und 69 dargestellt werden, durch die eine Verbindung zu den leitenden Belegungen 70 und 71 erfolgt. Die Belegung 70 weist einen Anschluß 72 auf, der mit der Versorgungsspannung beschaltet ist, während die Belegung 71 mit einem Anschluß A versehen ist, der dem Schaltungsausgang entspricht. Die Belegung 71 ist schließlich über weitere, im einzelnen nicht darstellte Schaltungsteile mit einem Anschluß 73 verbunden, der auf Bezugspotential liegt. Die Gates von T11 und T13 werden aus Streifen 74 und 75 aus polykristallinem Silizium gebildet, die über leitende Belegungen 76 und 77 mit zwei Schaltungseingängen E1 und E2 verbunden sind.

Ein weiterer paralleler Schaltungszweig, der ebenfalls die beiden Schaltungspunkte 68 und 69 miteinander verbindet und mit einem Feldeffekttransistor T12 bestückt ist, wird durch eine p-leitende Verbindungszone 78 realisiert, die zwei im Bereich der Schaltungspunkte 68 und 69 liegende Teilzonen der Anschlußzone 65 miteinander verbindet. Diese Verbindungszone wird lediglich durch das Kanalgebiet von T12 unterbrochen, das aus einem Teilbereich 79 der Wanne 64 besteht, der von einem Streifen 80 aus polykristallinem Silizium überdeckt wird. Die an den Teilbereich 79 angrenzenden Teile der Verbindungszone stellen das Source-und Draingebiet von T12 dar, der den Teilbereich 79 überdeckende Abschnitt des Streifens 80 die Gateelektrode. Der Streifen 80 ist über eine leitende Belegung 81 mit dem Eingang E3 der Schaltung verbunden.

Fig. 6 unterscheidet sich von Fig. 5 lediglich durch eine weitere p-leitende Verbindungszone 82, die zwei weitere Teilzonen der in sich geschlossenen Anschlußzone 65 miteinander verbindet. Die Verbindungszone 82 ist durch einen n-leitenden Teilbereich 83 der Wanne 64 unterbrochen, der von einem Abschnitt eines Streifens 84 aus polykristallinem Silizium überdeckt wird. Die an den Teilbereich 83 angrenzenden Teile der Verbindungszone 82 bilden das Source-und Draingebiet eines Transistors T14, der den Teilbereich 83 überdeckende Abschnitt 84 das Gate desselben. Der Streifen 84 ist über eine leitende Belegung 85 mit einem vierten Eingang E4 der Schaltung verbunden.

Bezugszeichenliste

1, 2 Schaltungszweige
3, 4 Schaltungspunkte
5, 6 Anschlüsse
7 Halbleiterkörper
8 Wanne
9 Anschlußzone
10, 11 Streifen aus polykristallinem Silizium
12, 13 Teilzonen von 9
14 Teilbereich von 8
15 Kontaktloch
16 leitende Belegung
17, 18 Teilzonen von 9
19 Kanalbereich
20 Kontaktloch
21 leitende Belegung
22 Ansatz von 9
23 Kontaktloch
24 leitende Belegung
25 Ansatz von 9
26 Kontaktloch
27 leitende Belegung
28 Kontaktloch
29a, b, c Zonen
30, 31 Teilbereiche von 7
32 Kontaktloch
33 leitende Belegung
34, 35 Schaltungszweige
36, 37 Schaltungspunkte
38, 39, 40 Schaltungszweige
41, 42 Schaltungspunkte
43 Halbleiterkörper
44 wannenförmige Zone
45 Anschlußzone
46, 47 Bereiche
48, 49 Streifen aus polykristallinem Silizium
50 Ansatz
51 leitende Belegung
52, 53 Anschlüsse
54 leitende Belegung
55a, b Zonen
56 Streifen aus polykristallinem Silizium
57, 58 leitende Belegungen
59 Ansatz von 60
60 Halbleiterzone
61 Ansatz von 60
62 leitende Belegung
63 Anschluß
64 Wanne
65 Anschlußzone
66, 67 Kanalgebiete
68, 69 Kontaktlöcher
70, 71 leitende Belegungen
72 Anschluß von 70
73 Anschluß
74, 75 Streifen aus polykristallinem Silizium
76, 77 leitende Belegungen
78 Verbindungszone
79 Teilgebiet von 64
80 Streifen aus polykristallinem Silizium
81 leitende Belegung
82 Verbindungszone
83 Teilbereich von 64
84 Streifen aus polykristallinem Silizium
85 leitende Belegung
T1...T14 Feldeffekttransistoren

E1, E2, E3 Eingänge
A Schaltungsausgang

## Ansprüche

1. Monolithisch integrierte Schaltung mit wenigstens zwei zwischen einem ersten und einem zweiten Schaltungspunkt (3, 4) liegenden, zueinander parallelen Schaltungszweigen (1, 2), die jeweils einen oder mehrere erste Feldeffekttransistoren (T1, T2) enthalten, **dadurch gekennzeichnet,** daß die Anschlußgebiete der in zweien dieser parallelen Schaltungszweige (1, 2) enthaltenen, ersten Feldeffekttransistoren (T1, T2) eine lediglich durch die Kanalgebiete (14, 19) derselben unterbrochene, im übrigen jedoch in sich geschlossene streifenförmige Anschlußzone (9) bilden.

2. Monolithisch integrierte Schaltung nach Anspruch 1, **dadurch gekennzeichnet,** daß die Anschlußgebiete der ersten Feldeffekttransistoren (T12) eines jeden weiteren, zwischen dem ersten und zweiten Schaltungspunkt (68, 69) liegenden, parallelen Schaltungszweiges eine lediglich durch die Kanalgebiete (79) dieser ersten Feldeffekttransistoren (T12) unterbrochene Verbindungszone (78) bilden, die zwei Teilzonen der streifenförmigen Anschlußzone (65) miteinander verbindet.

3. Monolithisch integrierte Schaltung nach Anspruch 1 oder 2, **dadurch gekennzeichnet,** daß sie als eine Gatterschaltung ausgebildet ist, wobei die parallelen Schaltungszweige (1, 2) über den ersten oder zweiten Schaltungspunkt (4) mit einem weiteren Schaltungszweig (5) verbunden sind, der einen oder mehrere zweite Feldeffekttransistoren (T3, T4) aufweist.

4. Monolithisch integrierte Schaltung nach Anspruch 3, **dadurch gekennzeichnet,** daß sie als eine CMOS-Schaltung ausgebildet ist, wobei der weitere Schaltungszweig in einem Halbleiterkörper (7) eines ersten Leitungstyps angeordnet ist und die parallelen Schaltungszweige in einer in den Halbleiterkörper eingefügten wannenförmigen Zone (8) liegen, die einen zu dem ersten Leitungstyp entgegengesetzten zweiten Leitungstyp aufweist.

5. Monolithisch integrierte Schaltung nach Anspruch 3, **dadurch gekennzeichnet,** daß sie als eine CMOS-Gatterschaltung ausgebildet ist, wobei die parallelen Schaltungszweige in einem Halbleiterkörper eines ersten Leitungstyps angeordnet sind und der weitere Schaltungszweig in einer in den Halbleiterkörper eingefügten wannenförmigen Zone liegt, die einen zu dem ersten Leitungstyp entgegengesetzten, zweiten Leitungstyp aufweist.

# FIG 1

# FIG 2

FIG 3

FIG 4

## FIG 5

## FIG 6